# EUROPEAN PATENT APPLICATION

(11) **EP 4 653 981 A1**
(43) Date of publication of application: **26.11.2025**
(21) Application number: 24764161.6
(22) Date of filing: 27.02.2024
(51) Int. Cl.: G06F 1/16, G06F 3/041

(54) **DISPLAY MODULE AND ELECTRONIC DEVICE COMPRISING SAME**

(30) Priority: 27.02.2023 KR 20230026285; 04.04.2023 KR 20230044243
(71) Applicant: Samsung Electronics Co., Ltd., Suwon-si, Gyeonggi-do 16677 (KR)
(72) Inventor: PARK, Kwangbok, Suwon-si, Gyeonggi-do 16677 (KR); SON, Jehyun, Suwon-si, Gyeonggi-do 16677 (KR); LEE, Hyomin, Suwon-si, Gyeonggi-do 16677 (KR)
(74) Representative: Gulde & Partner
(86) International application number: PCT/KR2024/002489
(87) International publication number: WO 2024/181762

(57) **Abstract**

An electronic device according to an embodiment of the present disclosure comprises: a first housing; a second housing connected to the first housing so as to be foldable with respect to the first housing; a first printed circuit board arranged in the first housing; a second printed circuit board arranged in the second housing; a display module which is disposed on the front surface of the electronic apparatus, partially deformed due to the movement of the second housing with respect to the first housing, and includes connection portions respectively connected to the first printed circuit board and the second printed circuit board; and at least one conductive circuit which is arranged in the display module and extends to the connection portions, and is electrically connected to the first printed circuit board and the second printed circuit board.

## Description

### [Technical Field]

Various embodiments disclosed herein relate to a display module and an electronic device including the same.

### [Background Art]

With the advancement of display technology, electronic devices that are capable of being transformed into various shapes are being provided. For example, a foldable electronic device with two housings that operate by folding or unfolding may be provided. The foldable electronic device may include a flexible display that is foldable together in response to the folding operation of the two housings. Meanwhile, since electrical components are respectively disposed in the two housings, an electrical structure for connection between the electrical components may be required.

### [Disclosure of Invention]

### [Technical Problem]

In an embodiment, a foldable electronic device may include two housings that are connected via a hinge device and operate in a folding or unfolding manner. Electrical components constituting the electronic device may be respectively disposed in the two housings. In order to connect multiple electrical components separated by the hinge device, a flexible printed circuit board passing through the hinge device may be used. As the foldable electronic device is folded or unfolded about the hinge device, the flexible printed circuit board passing through the hinge device may also be repeatedly folded or unfolded. In such a case, the flexible printed circuit board may be damaged.

### [Solution to Problem]

According to an embodiment of the disclosure, an electronic device may include a first housing, a second housing connected to the first housing to be foldable with respect to the first housing, a first printed circuit board disposed in the first housing, a second printed circuit board disposed in the second housing, a display module disposed on a front surface of the electronic device and including connection portions that are partially deformed by movement of the second housing relative to the first housing and are respectively connected to the first printed circuit board and the second printed circuit board, and one or more conductive circuits disposed in the display module and extending to the connection portions to be electrically connected to the first printed circuit board and the second printed circuit board.

According to an embodiment, in a display module, which is disposed in a foldable electronic device including a first housing and a second housing foldably connected to the first housing, the display module may include connection portions disposed in the display module and respectively connected to a first printed circuit board disposed in the first housing and a second printed circuit board disposed in the second housing, and one or more conductive circuits disposed in the display module extending to the connection portions and being electrically connected to the first printed circuit board and the second printed circuit board.

### [Advantageous Effects of Invention]

According to various embodiments disclosed herein, electrical components respectively disposed in two housings may be electrically connected by adding a signal line to the display module. In such a case, since a flexible printed circuit board for connecting the electronic components respectively disposed in the two housings is no longer necessary, the space for arranging electronic components in the electronic device may be expanded.

### [Brief Description of Drawings]

In connection with the description of the drawings, the same or similar components may be denoted by the same or similar reference numerals.
FIG. 1 is a block diagram of an electronic device according to an embodiment in a network environment.
FIGS. 2A and 2B are a front view and a rear view of an electronic device according to an embodiment of the disclosure in an unfolded state.
FIGS. 3A and 3B are a front view and a rear view of the electronic device according to an embodiment of the disclosure in a folded state.
FIG. 4 is an exploded perspective view of an electronic device according to an embodiment of the disclosure.
FIG. 5 is an exploded perspective view of a first display according to an embodiment of the disclosure.
FIG. 6A is a view illustrating a state in which a first printed circuit board and a second printed circuit board are connected via a first conductive circuit formed on a touch panel of a display module, according to an embodiment of the disclosure.
FIG. 6B is a view illustrating a stacked state of components constituting the display module, according to an embodiment of the disclosure.
FIG. 6C is a view illustrating a state in which the first conductive circuit of the display module extends to a first connection portion of the touch panel, according to an embodiment of the disclosure.
FIG. 6D is a view illustrating a state in which the first conductive circuit is formed on a protective layer of the display panel, according to an embodiment of the disclosure.
FIG. 7A is a view illustrating a state in which a first printed circuit board and a second printed circuit board are connected via a second conductive circuit formed on a digitizer panel of a display module, according to an embodiment of the disclosure.
FIG. 7B is a view illustrating a stacked state of components constituting the display module, according to an embodiment of the disclosure.
FIGS. 8A and 8B are views illustrating a connection between conductive circuits of a display module and first and printed circuit boards, according to an embodiment of the disclosure.

### [Mode for the Invention]

It should be appreciated that various embodiments of the present disclosure and the terms used therein are not intended to limit the technological features set forth herein to particular embodiments and include various changes, equivalents, or replacements for a corresponding embodiment.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

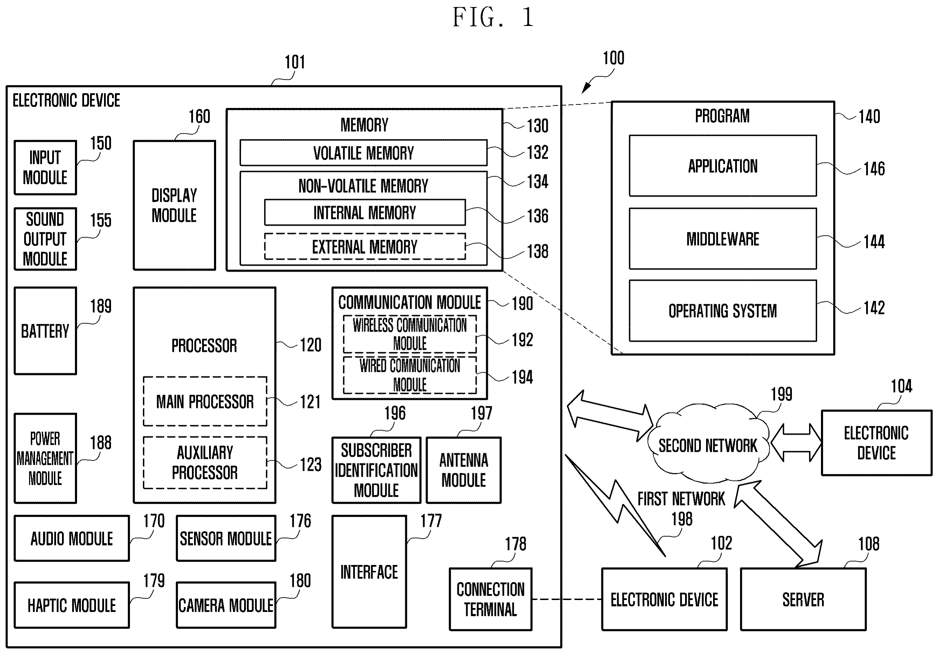

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semisupervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

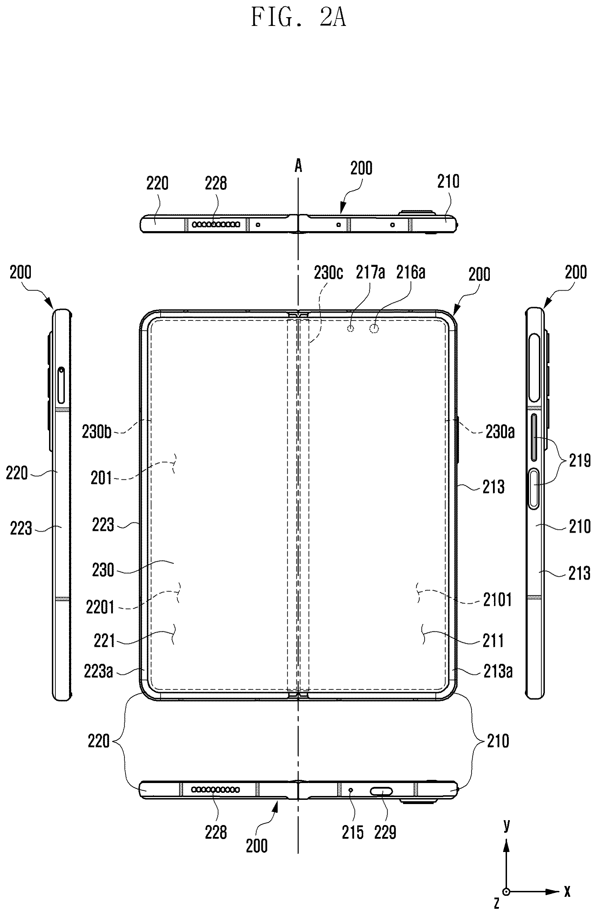

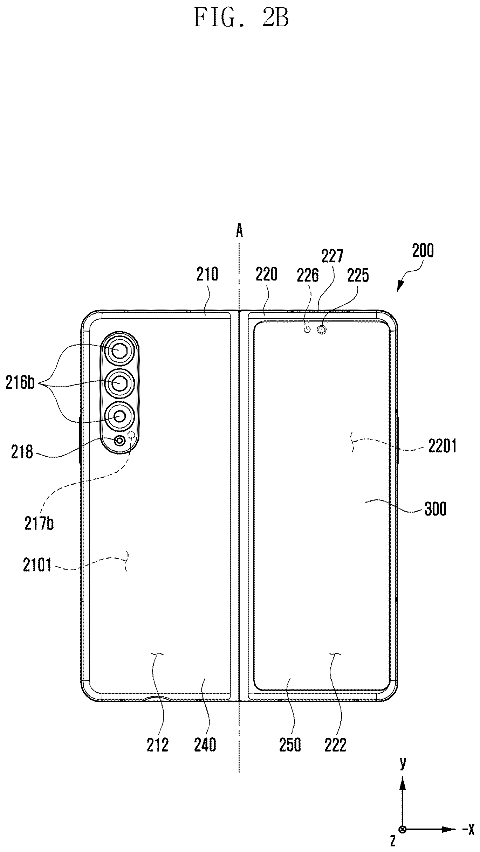

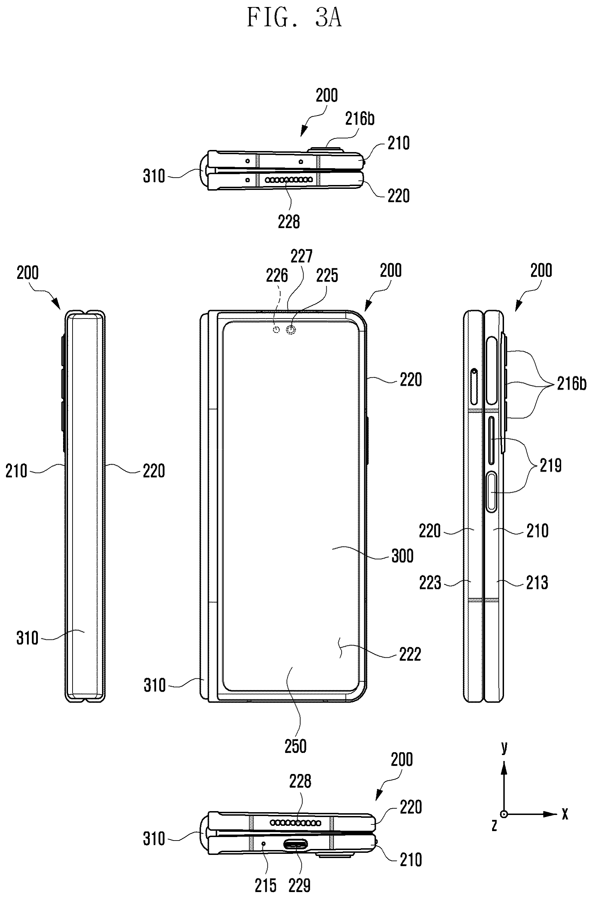

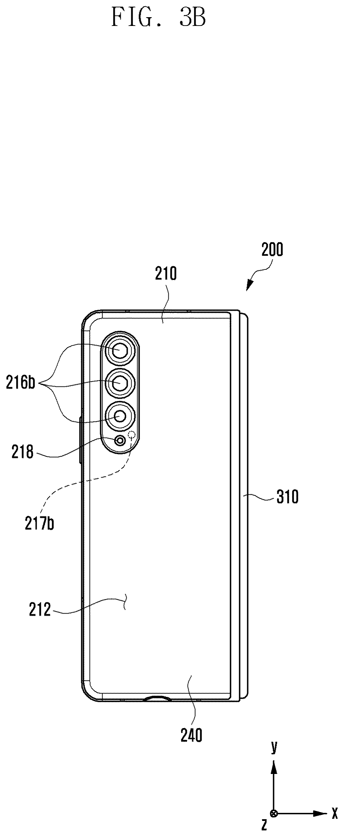

FIGS. 2A and 2B are a front view and a rear view of an electronic device according to an embodiment of the disclosure in an unfolded state. FIGS. 3A and 3B are a front view and a rear view of the electronic device according to an embodiment of the disclosure in a folded state.

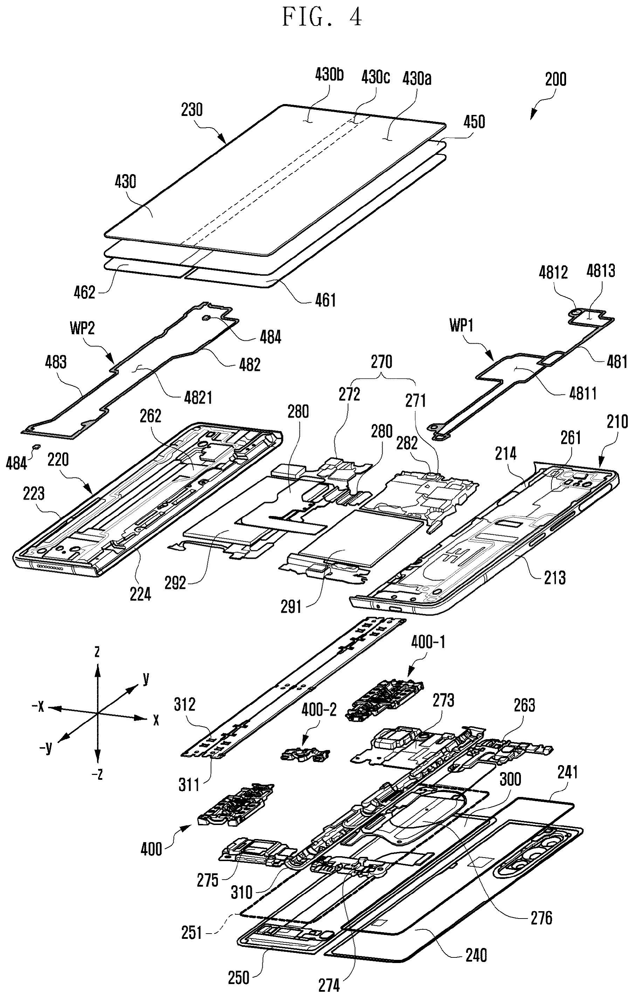

Referring to FIGS. 2A to 3B, an electronic device 200 may include a pair of housings 210 and 220 (e.g., a foldable housing structure) coupled to each other via a hinge device (e.g., the hinge devices 400 and 400-1 in FIG. 4) (e.g., a hinge module) to be rotatable about a folding axis A so as to be foldable relative to each other, a first display 230 (e.g., a flexible display, a foldable display, or a main display) disposed on the pair of housings 210 and 220, and/or a second display 300 (e.g., a sub-display) disposed on the second housing 220. According to an embodiment, at least a portion of the hinge device (e.g., the hinge devices 400 and 400-1 in FIG. 4) may be disposed to be invisible from the outside through the first housing 210 and the second housing 220, and may be disposed to be invisible from the outside through a hinge housing 310, which covers a foldable portion, in the unfolded state. Herein, the surface on which the first display 230 is disposed may be defined as the front surface of the electronic device 200, and the surface opposite to the front surface may be defined as the rear surface of the electronic device 200. In addition, the surface surrounding the space between the front surface and the rear surface may be defined as the side surface of the electronic device 200.

According to an embodiment, the pair of housings 210 and 220 may include a first housing 210 and a second housing 220 that are disposed to be foldable with respect to each other via the hinge device (e.g., the hinge devices 400 and 400-1 in FIG. 4). According to an embodiment, the pair of housings 210 and 220 are not limited to the shape and assembly illustrated in FIGS. 2A to 3B, but may be implemented by other shapes or other combinations and/or assemblies of components. According to an embodiment, the first housing 210 and the second housing 220 may be disposed on opposite sides of a folding axis A and may have shapes that are generally symmetrical to each other with respect to the folding axis A. According to some embodiments, the first housing 210 and the second housing 220 may be folded asymmetrically with respect to the folding axis A. According to an embodiment, the first housing 210 and the second housing 220 may form an angle or have a distance therebetween, which may be variable depending on whether the electronic device 200 is in the unfolded state, in the folded state, or in the intermediate state.

According to an embodiment, in the unfolded state of the electronic device 200, the first housing 210 may include a first surface 211 connected to the hinge device (e.g., the hinge devices 400 and 400-1 in FIG. 4) and arranged to face the front side of the electronic device 200, a second surface 212 facing away from the first surface 211, and/or a first side surface member 213 surrounding at least a portion of a first space between the first surface 211 and the second surface 212. According to an embodiment, in the unfolded state of the electronic device 200, the second housing 220 may include a third surface 221 connected to the hinge device (e.g., the hinges 400 and 400-1 in FIG. 4) and arranged to face the front side of the electronic device 200, a fourth surface 222 facing away from the third surface 221, and/or a second side surface member 223 surrounding at least a portion of a second space between the third surface 221 and the fourth surface 222. According to an embodiment, the first surface 211 may be oriented in substantially the same direction as the third surface 221 in the unfolded state and may at least partially face the third surface 221 in the folded state. According to an embodiment, the electronic device 200 may include a recess 201 provided to accommodate the first display 230 through structural coupling between the first housing 210 and the second housing 220. According to an embodiment, the recess 201 may have substantially the same size as the first display 230.

According to an embodiment, the hinge housing 310 (e.g., a hinge cover) may be disposed between the first housing 210 and the second housing 220 and disposed to cover a portion (e.g., at least one hinge module) of the hinge device (e.g., the hinge devices 400 and 400-1 in FIG. 4) disposed in the hinge housing 310. According to an embodiment, the hinge housing 310 may be covered by a portion of the first housing 210 and the second housing 220 or exposed to the outside, depending on whether the electronic device 200 is in the unfolded state, the folded state, or the intermediate state. For example, when the electronic device 200 is in the unfolded state, at least a portion of the hinge housing 310 may not be substantially exposed by being disposed to be covered by the first housing 210 and the second housing 220. According to an embodiment, when the electronic device 200 is in the folded state, at least a portion of the hinge housing 310 may be exposed to the outside between the first housing 210 and the second housing 220. According to an embodiment, when the electronic device is in the intermediate state in which the first housing 210 and the second housing 220 are folded with a certain angle, the hinge housing 310 may be disposed between the first housing 210 and the second housing 220 to be at least partially exposed to the outside of the electronic device 200. For example, the area of the hinge housing 310 exposed to the outside may be smaller than that in the case where the electronic device is fully folded. According to an embodiment, the hinge housing 310 may include a curved surface.

According to an embodiment, when the electronic device 200 is in the unfolded state (e.g., the state in FIGS. 2A and 2B), the first housing 210 and the second housing 220 form an angle of about 180 degrees therebetween, and the first area 230a, the second area 230b, and the folding area 230c of the first display 230 may be arranged to be oriented in substantially the same direction (e.g., the z-axis direction) while forming the same plane. According to an embodiment, when the electronic device 200 is in the unfolded state, the first housing 210 may rotate by an angle of about 360 degrees with respect to the second housing 220 to be folded in the opposite direction such that the second surface 212 and the fourth surface 222 face each other (out-folding type).

According to an embodiment, when the electronic device 200 is in the folded state (e.g., the state in FIGS. 3A and 3B), the first surface 211 of the first housing 210 and the third surface 221 of the second housing 220 may be disposed to face each other. In this case, the first area 230a and the second area 230b of the first display 230 may form a narrow angle (e.g., in the range of 0 degrees to about 10 degrees) with respect to each other via the folding area 230c, and may be disposed to face each other. According to an embodiment, at least a portion of the folding area 230c may be transformed into a curved shape with a predetermined curvature. According to an embodiment, when the electronic device 200 is in the intermediate state, the first housing 210 and the second housing 220 may be disposed to form a certain angle therebetween. In this case, the first area 230a and the second area 230b of the first display 230 may form an angle that is greater than that in the folded state and smaller than that in the unfolded state, and the curvature of the folding area 230c may be smaller than that in the folded state and greater than that in the unfolded state. In some embodiments, the first housing 210 and the second housing 220 may form an angle at which the first housing 210 and the second housing 220 can be stopped to form a predetermined folding angle between the folded state and the unfolded state via the hinge device (e.g., the hinge devices 400 and 400-1 in FIG. 4) (free stop function). In some embodiments, the first housing 210 and the second housing 220 may be continuously operated while being pressed in the unfolding direction and the folding direction with reference to a predetermined inflection angle via the hinge device (e.g., the hinge devices 400 and 400-1 in FIG. 4).

According to an embodiment, the electronic device 200 may include at least one of the following components: one or more displays 230 and 300, input devices 215, sound output devices 227 and 228, sensor modules 217a, 217b, and 226, camera modules 216a, 216b, and 225, key input devices 219, indicators (not illustrated), or connector ports 229 which are disposed on or in the first housing 210 and/or the second housing 220. In some embodiments, the electronic device 200 may omit at least one of the components, or additionally include at least one other component.

According to an embodiment, the one or more displays 230 and 300 may include a first display 230 (e.g., a display module 230) arranged to be supported by the first surface 211 of the first housing 210 to the third surface 221 of the second housing 220 across the hinge device (e.g., the hinge devices 400 and 400-1 in FIG. 4), and a second display 300 disposed in the inner space of the second housing 220 to be at least partially visible from the outside through the fourth surface 222. In some embodiments, the second display 300 may be disposed in the inner space of the first housing 210 to be visible from the outside through the second surface 212. According to an embodiment, the first display 230 may be mainly used when the electronic device 200 is in the unfolded state, and the second display 300 may be mainly used when the electronic device 200 is in the folded state. According to an embodiment, when the electronic device 200 is in the intermediate state, the electronic device 200 may be controlled such that the first display 230 and/or the second display 300 can be used based on the folding angle between the first housing 210 and the second housing 220.

According to an embodiment, the first display 230 may be placed in an accommodation space defined by the pair of housings 210 and 220. For example, the first display 230 may be disposed in the recess 201 defined by the pair of housings 210 and 220, and may be disposed to occupy substantially most of the front surface of the electronic device 200 in the unfolded state. According to an embodiment, the first display 230 may include a display module 230, at least a portion of which is transformable into a flat shape or a curved shape. According to an embodiment, the first display 230 may include a first area 230a facing the first housing 210, a second area 230b facing the second housing 220, and a folding area 230c interconnecting the first area 230a and the second area 230b and facing the hinge device (e.g., the hinge devices 400 and 400-1 in FIG. 4). In an embodiment, the area division of the first display 230 is only an exemplary physical division by the pair of housings 210 and 220 and the hinge device (e.g., the hinge devices 400 and 400-1 in FIG. 4), and the first display 230 may display a seamless single entire screen substantially with the pair of housings 210 and 220 and the hinge device (e.g., the hinge devices 400 and 400-1 in FIG. 4). According to an embodiment, the first area 230a and the second area 230b may have an overall symmetrical shape or a partially asymmetrical shape with respect to the folding area 230c.

According to an embodiment, the electronic device 200 may include a first rear surface cover 240 disposed on the second surface 212 of the first housing 210 and a second rear surface cover 250 disposed on the fourth surface 222 of the second housing 220. In some embodiments, at least a portion of the first rear surface cover 240 may be formed integrally with the first side surface member 213. In some embodiments, at least a portion of the second rear surface cover 250 may be integrated with the second side surface member 223. According to an embodiment, at least one of the first rear surface cover 240 and the second rear surface cover 250 may be made of a substantially transparent plate (e.g., a glass plate including various coating layers, or a polymer plate) or an opaque plate. According to an embodiment, the first rear surface cover 240 may be made of, for example, coated or colored glass, ceramic, polymer, metal (e.g., aluminum, stainless steel (STS), or magnesium), or an opaque plate such as a combination of two or more of these materials. According to an embodiment, the second rear surface cover 250 may be made of a substantially transparent plate of, for example, glass or polymer. Accordingly, the second display 300 may be disposed in the inner space of the second housing 220 to be visible from the outside through the second rear surface cover 250.

According to an embodiment, the input devices 215 may include a microphone. In some embodiments, the input devices 215 may include a plurality of microphones disposed to detect the direction of sound. According to an embodiment, the sound output devices 227 and 228 may include speakers. In an embodiment, the sound output devices 227 and 228 may include a call receiver 227 disposed through the fourth surface 222 of the second housing 220, and an external speaker 228 disposed through at least a portion of the second side surface member 223 of the second housing 220. In some embodiments, the input devices 215, the sound output devices 227 and 228, and the connector ports 229 may be disposed in the spaces of the first housing 210 and/or the second housing 220, and may be exposed to the external environment through one or more holes provided in the first housing 210 and/or the second housing 220. In some embodiments, the holes provided in the first housing 210 and/or the second housing 220 may be commonly used for the input device 215 and the sound output devices 227 and 228. In some embodiments, the sound output devices 227 and 228 may include a speaker that operates without holes provided in the first housing 210 and/or the second housing 220 (e.g., a piezo speaker).

According to an embodiment, the camera modules 216a, 216b, and 225 may include a first camera module 216a disposed on the first surface 211 of the first housing 210, a second camera module 216b disposed on the second surface 212 of the first housing 210, and/or a third camera module 225 disposed on the fourth surface 222 of the second housing 220. In an embodiment, the electronic device 200 may include a flash 218 located near the second camera module 216b. According to an embodiment, the flash 218 may include, for example, a light-emitting diode or a xenon lamp. According to an embodiment, the camera modules 216a, 216b, and 225 may include one or more lenses, an image sensor, and/or an image signal processor. In some embodiments, at least one of the camera modules 216a, 216b, and 225 may include two or more lenses (e.g., wide-angle and telephoto lenses) and image sensors, and the camera modules may be disposed together on one surface of the first housing 210 and/or the second housing 220.

According to an embodiment, the sensor modules 217a, 217b, and 226 may generate electrical signals or data values corresponding to an internal operating state or an external environmental state of the electronic device 200. According to an embodiment, the sensor modules 217a, 217b, and 226 may include a first sensor module 217a disposed on the first surface 211 of the first housing 210, a second sensor module 217b disposed on the second surface 212 of the first housing 210, and/or a third sensor module 226 disposed on the fourth surface 222 of the second housing 220. In some embodiments, the sensor modules 217a, 217b, and 226 may include at least one of a gesture sensor, a grip sensor, a color sensor, an infrared (IR) sensor, an illumination sensor, an ultrasonic sensor, an iris recognition sensor, or a distance detection sensor (e.g., a time-of-flight (TOF) sensor or a light detection and ranging (LiDAR)).

According to an embodiment, the electronic device 200 may further include at least one of sensor modules (not illustrated), for example, an air pressure sensor, a magnetic sensor, a biometric sensor, a temperature sensor, a humidity sensor, or a fingerprint recognition sensor. In some embodiments, the fingerprint recognition sensor may be disposed through at least one of the first side surface member 213 of the first housing 210 and/or the second side surface member 223 of the second housing 220.

According to an embodiment, the key input devices 219 may be disposed to be exposed outside through the first side surface member 213 of the first housing 210. In some embodiments, the key input devices 219 may be disposed to be exposed outside through the second side surface member 223 of the second housing 220. In some embodiments, the electronic device 200 may not include some or all of the above-mentioned key input devices 219, and a key input device 219, which is not included, may be implemented in another form, such as a soft key, on at least one display 230 or 300. According to an embodiment, the key input devices 219 may be implemented by using a pressure sensor included in the at least one display 230 or 300.

According to an embodiment, the connector ports 229 may include a connector (e.g., a USB connector or an interface connector port module (IF module)) configured to transmit/receive power and/or data to/from an external electronic device. In some embodiments, the connector ports 229 may further include a separate connector port (e.g., an ear jack hole) for performing a function to transmit/receive an audio signal together with an external electronic device or for performing a function to transmit/receive an audio signal.

According to an embodiment, one or more camera modules 216a and 225 among the camera modules 216a, 216b, and 225, one or more sensor modules 217a and 226 among the sensor modules 217a, 217b, and 226, and /or an indicator may be disposed to be exposed through one or more displays 230 and 300. For example, the at least one camera module 216a or 225, the at least one sensor module 217a or 226, and/or the indicator may be disposed in the inner space of the at least one housing 210 or 300 below the active area (display area) of the at least one display 230 or 300, and may be disposed to come into contact with the external environment through an opening perforated up to the cover member (e.g., a window layer (not illustrated) of the first display 230 and/or the second rear surface cover 250) or a transparent area. According to an embodiment, an area in which the at least one display 230 or 300 and the at least one camera module 216a or 225 face each other may be provided as a transmission area with a predetermined transmittance as a portion of a content display area. According to an embodiment, the transmission area may have a transmittance ranging from about 5% to about 20%. The transmissive area may include an area overlapping the effective area (e.g., a view angle area) of the at least one camera module 216a or 225 through which light imaged by an image sensor to generate an image passes. For example, the transmissive area of the display 230 or 300 may include an area having a lower pixel density than the periphery. For example, the transmissive area may replace an opening. For example, the at least one camera module 216a or 225 may include an under-display camera (UDC) or an under-panel camera (UPC). According to an embodiment, some camera modules or sensor modules 217a and 226 may be disposed to perform the functions thereof without being visually exposed through a display. For example, the areas facing the camera modules 216a and 225 and/or the sensor modules 217a and 226 disposed under the displays 230 and 300 (e.g., a display panel) may have an under-display camera (UDC) structure, and may not require a perforated opening.

FIG. 4 is an exploded perspective view illustrating the electronic device 200 according to various embodiments of the disclosure.

Referring to FIG. 4, the electronic device 200 may include a first display 230 (e.g., a display module 230), a second display 300, hinge devices 400 and 400-1, a pair of support members 261 and 262, at least one substrate 270 (e.g., a printed circuit board (PCB)), a first housing 210, a second housing 220, a first rear surface cover 240, and/or a second rear surface cover 250.

According to an embodiment, the first display 230 may include a display panel 430 (e.g., a flexible display panel), a support plate 450 disposed below the display panel 430, and a pair of reinforcement plates 461 and 462 disposed below the support plate 450. According to an embodiment, the display panel 430 may include a first panel area 430a corresponding to a first area (e.g., the first area 230a in FIG. 2A) of the first display 230, a second panel area 430b extending from the first panel area 430a and corresponding to a second area (e.g., the second area 230b in FIG. 2A) of the first display 230, and a third panel area 430c interconnecting the first panel area 430a and the second panel area 430b and corresponding to a folding area (e.g., the folding area 230c in FIG. 2A) of the first display 230. According to an embodiment, the support plate 450 may be disposed between the display panel 430 and a pair of support members 261 and 262 and may be configured to have a material and a shape to provide a flat support structure for the first panel area 430a and the second panel area 430b and a bendable structure for supporting bendability of the third panel area 430c. According to an embodiment, the support plate 450 may be made of a conductive material (e.g., metal) or a non-conductive material (e.g., polymer or fiber reinforced plastics (FRP)). According to an embodiment, the pair of reinforcement plates 461 and 462 may include, between the support plate 450 and the pair of support members 261 and 262, a first reinforcement plate 461 disposed corresponding to at least a portion of the first panel area 430a and the third panel area 430c, and a second reinforcement plate 462 disposed corresponding to at least a portion of the second panel area 430b and the third panel area 430c. According to an embodiment, the pair of reinforcement plates 461 and 462 may be made of a metal material (e.g., SUS) to help reinforce the ground connection structure and rigidity for the first display 230.

According to an embodiment, the second display 300 may be disposed in the space between the second housing 220 and the second rear surface cover 250. According to an embodiment, the second display 300 may be disposed in the space between the second housing 220 and the second rear surface cover 250 to be visible from the outside through substantially the entire area of the second rear surface cover 250.

According to an embodiment, at least a portion of the first support member 261 may be coupled to the second support member 262 to be foldable via the hinge device 400 and 400-1. According to an embodiment, the electronic device 200 may include at least one wiring member 280 (e.g., a flexible printed circuit board (FPCB)) extending from at least a portion of the first support member 261 to a portion of the second support member 262 across the hinge devices 400 and 400-1. According to an embodiment, the first support member 261 may extend from the first side surface member 213 or may be disposed in a manner of being structurally coupled with the first side surface member 213. According to an embodiment, the electronic device 200 may include a first space (e.g., the first space 2101 in FIG. 2A) provided by the first support member 261 and the first rear surface cover 240. According to an embodiment, the first housing 210 (e.g., the first housing structure) may be configured through the coupling of the first side surface member 213, the first support member 261, and the first rear surface cover 240. According to an embodiment, the second support member 262 may extend from the second side surface member 223 or may be disposed in a manner of being structurally coupled with the second side surface member 223. According to an embodiment, the electronic device 200 may include a second space (e.g., the second space 2201 in FIG. 2A) provided by the second support member 262 and the second rear surface cover 250. According to an embodiment, the second housing 220 (e.g., the second housing structure) may be configured through the coupling of the second side surface member 223, the second support member 262, and the second rear surface cover 250. According to an embodiment, at least a portion of the at least one wiring member 280 and/or the hinge devices 400 and 400-1 may be disposed to be supported by at least a portion of the pair of support members 261 and 262. According to an embodiment, the at least one wiring member 280 may be arranged in a direction across the first support member 261 and the second support member 262 (e.g., in the x-axis direction). According to an embodiment, the at least one wiring member 280 may be arranged in a direction (e.g., the x-axis direction) substantially perpendicular to the folding axis (e.g., the y-axis or the folding axis A1 in FIG. 2A).

According to an embodiment, the one or more substrates 270 may include a first substrate 271 disposed in the first space 2101 and a second substrate 272 disposed in the second space 2201. According to an embodiment, the first substrate 271 and the second substrate 272 may include a plurality of electronic components disposed thereon to implement various functions of the electronic device 200. According to an embodiment, the first substrate 271 and the second substrate 272 may be electrically connected to each other via at least one wiring member 280. In an embodiment, a camera module 282 may be disposed on the first substrate 271.

According to an embodiment, the electronic device 200 may include one or more batteries 291 and 292. According to an embodiment, the at least one battery 291 or 292 may include a first battery 291 disposed in the first space 2101 of the first housing 210 and electrically connected to the first substrate 271 and a second battery disposed in the second space 2201 of the second housing 220 and electrically connected to the second substrate 272. According to an embodiment, the first support member 261 and the second support member 262 may further include one or more swelling holes for the first battery 291 and the second battery 292.

According to an embodiment, the first housing 210 may include a first rotation support surface 214, and the second housing 220 may include a second rotation support surface 224 corresponding to the first rotation support surface 214. According to an embodiment, the first rotation support surface 214 and the second rotation support surface 224 may each include a curved surface corresponding to (naturally connected to) the curved outer surface of the hinge housing 310. According to an embodiment, when the electronic device 200 is in the unfolded state, the first rotation support surface 214 and the second rotation support surface 224 may cover the hinge housing 310 to prevent the hinge housing 310 from being exposed to the rear surface of the electronic device 200 or to expose only a portion of the hinge housing 310 to the rear surface of the electronic device 200. According to an embodiment, when the electronic device 200 is in the folded state, the first rotation support surface 214 and the second rotation support surface 224 may rotate along the curved outer surface of the hinge housing 310 to at least partially expose the hinge housing 310 to the rear surface of the electronic device 200.

According to an embodiment, the electronic device 200 may include at least one antenna 276 disposed in the first space 2101. According to an embodiment, the at least one antenna 276 may be disposed on the first battery 291 and the first rear surface cover 240 in the first space 2101. According to an embodiment, the at least one antenna 276 may include, for example, a near-field communication (NFC) antenna, a wireless charging antenna, and/or a magnetic secure transmission (MST) antenna. According to an embodiment, the at least one antenna 276 may execute, for example, short-range communication with an external device or wireless transmission/reception of power required for charging. In some embodiments, an antenna structure may be configured by at least a portion of the first side surface member 213 or the second side surface member 223 and/or a portion of the first support member 261 and the second support member 262, or a combination thereof.

According to an embodiment, the electronic device 200 may further include at least one electronic component assembly 274 or 275 and/or additional support members 263 and 273 disposed in the first space 2101 and/or the second space 2201. For example, the at least one electronic component assembly may include an interface connector port assembly 274 or a speaker assembly 275.

According to an embodiment, the electronic device 101 may include a first waterproof structure WP1 disposed between the first reinforcement plate 461 and the first support member 261 and a second waterproof structure WP2 disposed between the second reinforcement plate 462 and the second support member 262. According to an embodiment, the first waterproof structure WP1 may include a first waterproof member 481 disposed to form at least one first waterproof space 4811, 4812, or 4813 between the first reinforcement plate 461 and the first support member 261. According to an embodiment, the second waterproof structure WP2 may include a second waterproof member 482 (e.g., a (2-1)^{th} waterproof member 482), a third waterproof member 483 (e.g., a (2-2)^{th} waterproof member 483), and a fourth waterproof member 484 (e.g., a (2-3)^{th} waterproof member 484), which are arranged between the second reinforcing plate 462 and the second support member 262 so as to form at least one second waterproof space 4821. According to an embodiment, the fourth waterproof member 484 may be disposed to interconnect stepped and spaced spaces of the second waterproof member 482 and the third waterproof member 483.

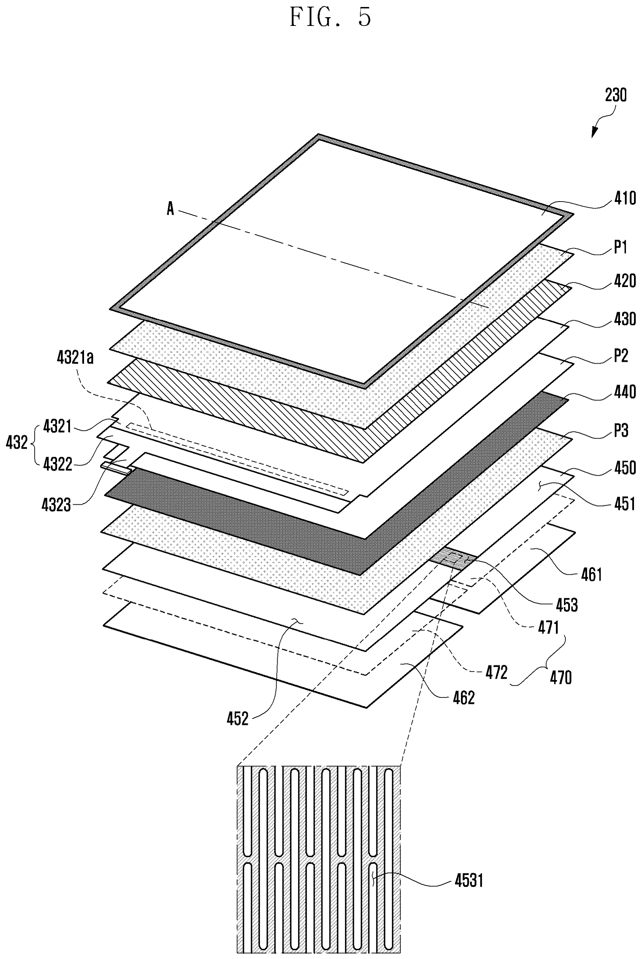

According to various embodiments, the at least one first waterproof space 4811 may be disposed to accommodate a penetration path of a connection member (a flexible printed circuit board (FPCB)) as a wiring structure for connecting an electronic component (e.g., the first digitizer panel 471 in FIG. 5) disposed between the first reinforcement plate 461 and the first support member 261 to the first space 2101 through the first waterproof member 481. According to an embodiment, the at least one second waterproof space 4821 may be disposed to accommodate a penetration path of a connection member as a wiring structure for connecting an electronic component (e.g., the second digitizer panel 472 in FIG. 5) disposed between the second reinforcement plate 462 and the second support member 262 to the second space 2201 through the second waterproof member 482, the third waterproof member 483, and the fourth waterproof member 484. According to an embodiment, the at least one first waterproof space 4812 or 4813 may accommodate an area corresponding to at least one electronic component (e.g., a camera module or a sensor module) disposed to be supported by the first support member 261. According to an embodiment, the at least one second waterproof space 4821 may accommodate at least a portion of a bending portion (e.g., the bending portion 432 in FIG. 5) that is folded toward the rear surface of the first display 230. For example, the at least one second waterproof space 4821 may be disposed to surround at least a portion of the bending portion 432 that extends from the display panel (e.g., the display panel 430 in FIG. 5) of the first display 230 and is folded to the rear surface. Accordingly, a control circuit (e.g., the control circuit 4321a in FIG. 5) and multiple electrical elements (not illustrated) disposed in the bending portion 432 may be protected from external moisture and/or foreign substances by being disposed in the at least one second waterproof space 4821.

In the electronic device 200 according to an exemplary embodiment of the disclosure, at least one waterproof member 481, 482, 483, or 484 includes at least one waterproof structure WP1 or WP2 disposed between the first support member 261 and the first reinforcement plate 461 of the first housing 210 and/or between the second support member 262 and the second reinforcement plate 462 of the second housing 220. Therefore, the phenomenon of the first display being damaged through the waterproof member may be reduced when separating the first display 230 from the housings 210 and 220 for the maintenance of the electronic device 200. In addition, the at least one waterproof member 481, 482, 483, or 484 is disposed to avoid the rear surface of the first display 230, which may improve external visibility and help ensure surface quality.

FIG. 5 is an exploded perspective view of a display module according to an embodiment disclosed herein. The display module in FIG. 5 may be an example of the first display (e.g., the first display 230 in FIGS. 2A and 4) previously described with reference to FIGS. 2A and 4.

The display module 230 according to exemplary embodiments of the disclosure may include an unbreakable (UB)-type OLED display (e.g., a curved display). However, the disclosure is not limited thereto, and the display module 230 may include a flat-type display of an on-cell-touch active-matrix organic light-emitting diode (AMOLED) (OCTA) type.

Referring to FIG. 5, the display module 230 may include a window layer 410, and a polarizer (POL) 420 (e.g., a polarizing film), a display panel 430, a polymer layer 440, a support plate 450, and reinforcement plates 461 and 462, which are sequentially disposed on the rear surface of the window layer 410 (e.g., in the -z-axis direction in FIG. 4). In some embodiments, a damping layer may be disposed between a window layer 410 and a display panel 430 instead of a polarizer 420 in the display module 230. In addition, in some embodiments, the damping layer may be disposed above or below the polarizer 420.

In an embodiment, the display module 230 may include a digitizer panel 470 disposed between the support plate 450 and the reinforcement plates 461 and 462. In an embodiment, the digitizer panel 470 may be disposed between the polymer layer 440 and the support plate 450. Although not illustrated in the drawings, in an embodiment, a buffer member (not illustrated) may be disposed between a window layer 410 and a support plate 450. The buffer member may mitigate impact transmitted from the window layer 410 to the support plate 450.

According to an embodiment, the window layer 410 may include a glass layer. In some embodiments, a protective film (protective layer) may be disposed on the window layer 410. For example, the protective film may be disposed above the window layer 410 to protect it from external impacts. According to an embodiment, the window layer 410 may include ultra-thin glass (UTG). In some embodiments, the window layer 410 may include polymer. In this case, the window layer 410 may include polyethylene terephthalate (PET) or polyimide (PI). In some embodiments, the window layer 410 may be arranged in multiple layers to include a glass layer and a polymer.

According to an embodiment, the window layer 410, the polarizer 420, the display panel 430, the polymer layer 440, and the support plate 450 may be disposed to cross at least a portion of the first surface (e.g., the first surface 211 in FIG. 2A) of the first housing (e.g., the first housing 210 in FIG. 2A) and the third surface (e.g., the third surface 221 in FIG. 2A) of the second housing (e.g., the second housing 220 in FIG. 2A). According to an embodiment, the reinforcement plates 461 and 462 may include a first reinforcement plate 461 corresponding to the first housing (e.g., the first housing 210 in FIG. 2A) and a second reinforcement plate 462 corresponding to the second housing (e.g., the second housing 220 in FIG. 2A). According to an embodiment, the reinforcement plates 461 and 462 may provide rigidity for the display module 230 and may be used as a ground to prevent or reduce malfunction of the display module 230. According to an embodiment, the reinforcement plates 461 and 462 may be made of a metal material. According to an embodiment, the reinforcement plates 461 and 462 may be made of SUS, Cu or Al. According to an embodiment, the window layer 410, the polarizer 420, the display panel 430, the polymer layer 440, the support plate 450, and the reinforcement plates 461 and 462 may be bonded to each other by adhesives P1, P2, and P3 (or a bonding material). For example, the adhesives P1, P2, and P3 may include at least one of an optical clear adhesive (OCA), a pressure-sensitive adhesive (PSA), a heat-responsive adhesive, a general adhesive, and double-sided tape.

According to an embodiment, the display panel 430 may include a plurality of pixels and a wiring structure (e.g., an electrode pattern). According to an embodiment, the polarizer 420 may selectively make light, which is generated from a light source of the display panel 430 and vibrates in a predetermined direction, pass therethrough. According to an embodiment, the display panel 430 and the polarizer 420 may be integrally configured. According to an embodiment, the display module 230 may include a touch panel (not illustrated).

According to an embodiment, the display panel 430 constituting the display module 230 (e.g., the display module 160 of FIG. 1 or the first display 230 of FIG. 2A) may include a flexible substrate 4322, some of a plurality of light-emitting elements (e.g., oxide light-emitting diodes (OLEDs) or light-emitting diodes (LEDs)) disposed on the flexible substrate 4322, a thin film transistor (TFT) layer electrically connected to the light-emitting elements, and/or a protective layer 431 that protects the TFT layer. In an embodiment, the display panel may have a stacked structure in the order of the flexible substrate 4322, the TFT layer, and the protective layer 431.

According to an embodiment, the polymer layer 440 may be disposed under the display panel 430 to provide a dark background for securing visibility of the display panel 430, and may be made of a buffering material for a buffering action. In some embodiments, in order to ensure waterproofing of the display module 230, the polymer layer 440 may be removed or disposed under the support plate 450.

According to an embodiment, the support plate 450 may provide a bendable property to the display module 230. For example, the support plate 450 may be made of a non-metallic sheet material, such as fiber-reinforced plastics (FRP) (e.g., carbon fiber-reinforced plastics (CFRP) or glass fiber-reinforced plastics (GFRP)), having a rigid property to support the display panel 430. According to an embodiment, the support plate 450 may include a first flat portion 451 corresponding to the first housing (e.g., the first housing 210 in FIG. 2A), a second flat portion 452 corresponding to the second housing (e.g., the second housing 220 in FIG. 2A), and a bending portion 453 (a flexible portion or a bending portion) interconnecting the first flat portion 451 and the second flat portion 452. According to an embodiment, the bending portion 453 may include multiple openings 4531 arranged at predetermined intervals. According to an embodiment, the bending property of the bending portion 453 may be determined based on at least one of a size, a shape, or an arrangement density of at least some of the multiple openings 4531. In some embodiments, the support plate 450 may be made of a metal material such as steel use stainless (SUS) (e.g., stainless steel (STS)), Cu, Al, or a metal CLAD (e.g., a laminated member in which SUS and Al are alternately disposed). In this case, throughout the entire area of the support plate 450, the multiple openings may be formed to induce the detection operation of the digitizer panel 470 disposed below the support plate. According to an embodiment, the support plate 450 may help reinforce the rigidity of the electronic device (e.g., the electronic device 200 in FIG. 2A), and may be used to shield ambient noise and dissipate heat emitted from surrounding heat dissipating components.

According to an embodiment, the display 230 may include a digitizer panel 470 as a detection member disposed under the support plate 450 and receiving an input of an electronic pen (e.g., a stylus). According to an embodiment, the digitizer panel 470 may include coil members disposed on a dielectric substrate (e.g., a dielectric film or a dielectric sheet) to detect an electromagnetically induced resonance frequency applied by the electronic pen. According to an embodiment, the digitizer panel 470 may include a first digitizer panel 471 corresponding to the first housing (e.g., the first housing 210 in FIG. 2A) and a second digitizer panel 472 corresponding to the second housing (e.g., the second housing 220 in FIG. 2A). According to an embodiment, each of the first digitizer panel 471 and the second digitizer panel 472 is electrically connected to substrates (e.g., the substrates 271 and 272 in FIG. 4) of an electronic device (e.g., the electronic device 200 in FIG. 4) via a connection member (not illustrated) so that the first and second digitizer panels may operate as a single digitizer panel. In some embodiments, the first digitizer panel 471 and the second digitizer panel 472 may be operated separately. In some embodiments, the first digitizer panel 471 and the second digitizer panel 472 may be formed integrally and operated separately.

According to an embodiment, the display module 230 may include one or more functional members (not illustrated) disposed between the polymer layer 440 and the support plate 450 or below the support plate 450. According to an embodiment, the functional members may include a graphite sheet for heat dissipation, an added display, a force touch FPCB, a fingerprint sensor FPCB, a communication antenna radiator, or conductive/non-conductive tape. According to an embodiment, when the functional members are not bendable, the functional members may be separately disposed in the first housing (e.g., the first housing 210 in FIG. 2A) and the second housing (e.g., the second housing 220 in FIG. 2A). According to an embodiment, when the functional members are bendable, the functional members may be disposed from the first housing (e.g., the first housing 210 in FIG. 2A) to at least a portion of the second housing (e.g., the second housing 220 in FIG. 2A) across the hinge devices (e.g., the hinge devices 400 and 400-1 in FIG. 4).

According to an embodiment, the display module 230 may include a bending portion 432 disposed in a manner of being folded from the display panel 430 to at least a portion of the rear surface (e.g., -z-axis direction in FIG. 4) of the display module 230. According to an embodiment, the bending portion 432 may include an extension 4321 extending from the display panel 430 and including a control circuit 4321a, and a flexible substrate 4322 electrically connected to the extension 4321 and including multiple electrical elements. According to an embodiment, the control circuit 4321a may include a display driver IC (DDI) or a touch display driver IC (TDDI) disposed on the extension 4321 having an electrical wiring structure. According to an embodiment, the control circuit 4321a may have a chip-on-panel or chip-on-plastic (COP) structure disposed directly on the extension 4321. In some embodiments, the control circuit 4321a may have a chip-on-film (COF) structure disposed on a separate connection film (not illustrated) interconnecting the extension portion 4321 and the flexible board 4322. According to an embodiment, the display module 230 may include multiple electrical elements (not illustrated) disposed on the flexible board 4322. According to an embodiment, the display module 230 may include a connection member 4323 extending from the flexible board 4322 and electrically connected to a substrate (e.g., the second substrate 272 in FIG. 4) of the electronic device (e.g., the electronic device 200 of FIG. 4). According to an embodiment, the multiple electrical elements may include passive elements such as a touch IC, a display flash memory, an ESD prevention diode, a pressure sensor, a fingerprint sensor, or a decap. According to an embodiment, when the bending portion 432 is disposed in a region of the display module 230 facing the first housing (e.g., the first housing 210 in FIG. 2A), the connection member 4323 may be electrically connected to another board (e.g., the first substrate 271 in FIG. 4) of the electronic device (e.g., the electronic device 200 in FIG. 4).

According to an embodiment, the one or more hinge devices 400 and 400-1 may include a first hinge device 400 disposed at one end in a direction parallel to the folding axis A and a second hinge device 400-1 disposed at the other end. According to an embodiment, the first hinge device 400 and the second hinge device 400-1 may have substantially the same configuration. According to an embodiment, the electronic device 200 may include a connection module 400-2 disposed between the first hinge device 400 and the second hinge device 400-1. According to an embodiment, the connection module 400-2 may be disposed through a combination of one or more gears and/or a combination of one or more links. In an embodiment, the connection module 400-2 may be replaced with the first hinge device 400. In an embodiment, the one or more hinge devices 400 and 400-1 may be disposed at one location or three or more locations spaced apart at a predetermined interval along a direction parallel to the folding axis A. According to an embodiment, the electronic device 200 may include a first hinge plate 311 and a second hinge plate 312 connected via the one or more hinge devices 400 and 400-1. According to an embodiment, when the electronic device 200 is in the unfolded state, the first hinge plate 311 may form the same plane as the first housing 210, and when the electronic device 200 is in the unfolded state, the second hinge plate 312 may form the same plane as the second housing 220. According to an embodiment, when the electronic device 200 is in the folded state, the first display 230 may be transformed into a shape having a predetermined curved surface (e.g., a "U" shape or a water drop shape) and accommodated in the inner space of the electronic device 200 through the one or more hinge devices 400 and 400-1. According to an embodiment, when the electronic device 200 is in the folded state, the first hinge plate 311 and the second hinge plate 312 may be moved to support at least a portion of the folding area (e.g., the folding area 230c in FIG. 2A) transformed into a shape having a curved surface in the first display 230. In an embodiment, when the electronic device 200 is in the folded state, the first housing 210 and the second housing 220 may be moved to support substantially untransformed flat portions of the first display 230 (e.g., the first area 230a and the second area 230b in FIG. 2A). In an embodiment, the electronic device 200 is in the folded state, the first hinge plate 311 may not form the same flat surface as the first housing 210, and the second hinge plate 312 may also not form the same flat surface as the second housing 220.

The display module 230 described above is only an example for describing the disclosure, and the display module 230 does not necessarily include all of the components described above. Accordingly, it may be possible to configure the display module 230 by omitting some of the components described above or adding some of the components.

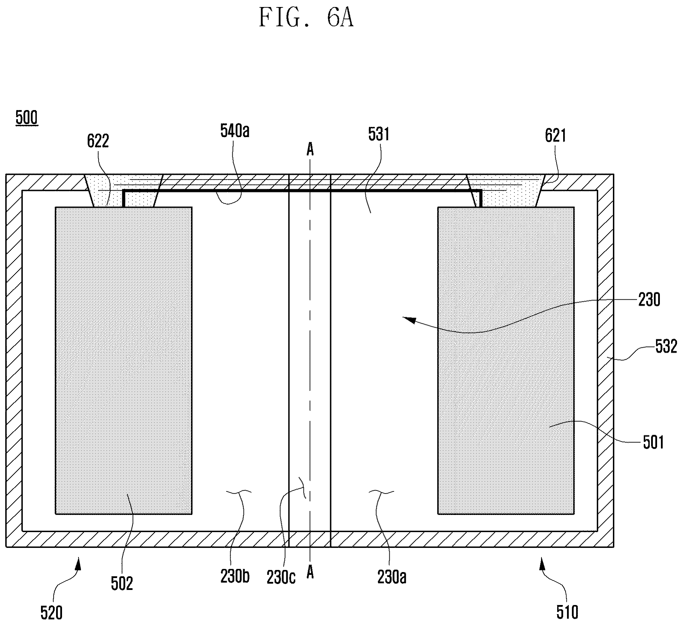

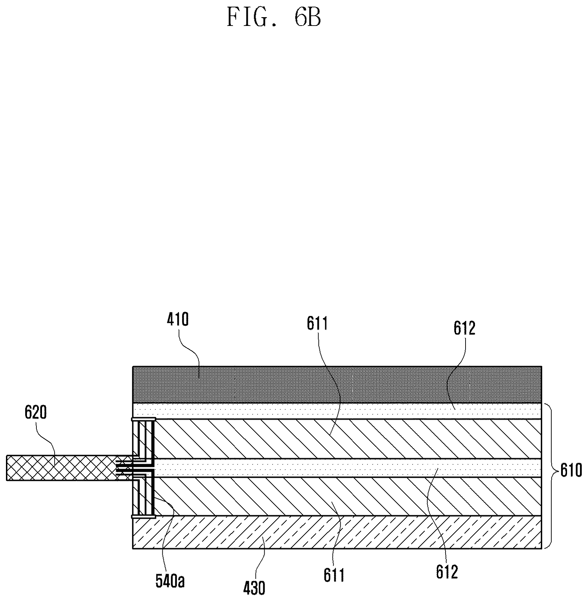

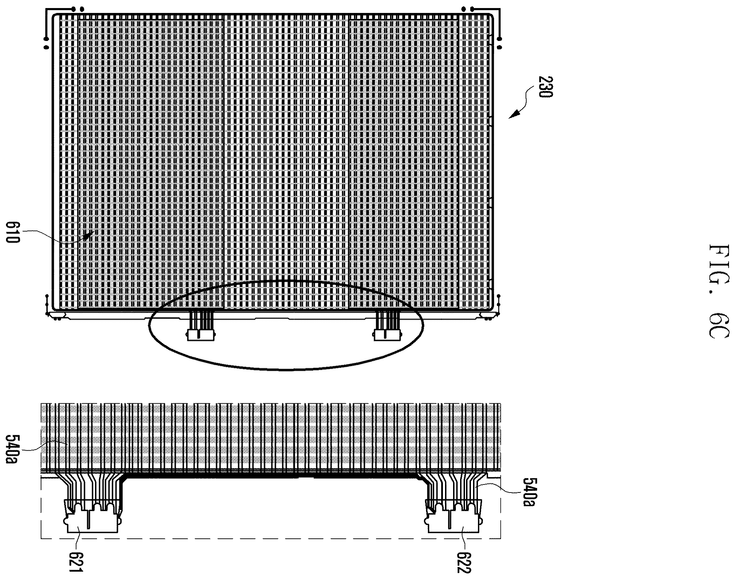

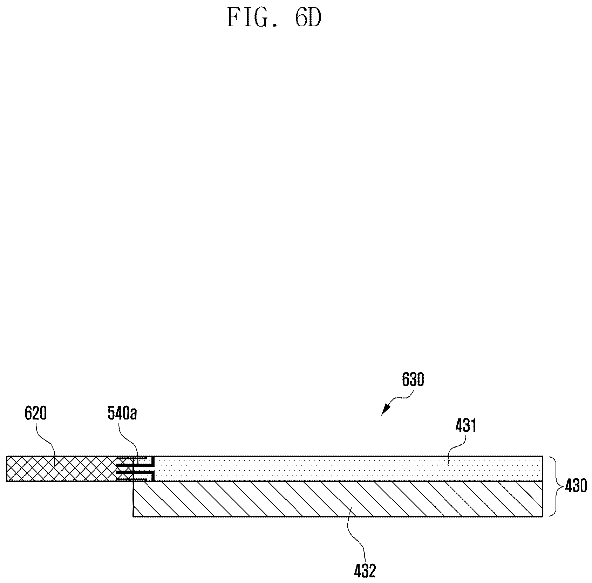

FIG. 6A is a view illustrating a state in which a first printed circuit board and a second printed circuit board are connected via a first conductive circuit formed on a touch panel of a display module, according to an embodiment of the disclosure. FIG. 6B is a view illustrating a stacked state of components constituting the display module, according to an embodiment of the disclosure. FIG. 6C is a view illustrating a state in which the first conductive circuit of the display module extends to a first connection portion of the touch panel, according to an embodiment of the disclosure. FIG. 6D is a view illustrating a state in which the first conductive circuit is formed on a protective layer of the display panel, according to an embodiment of the disclosure.

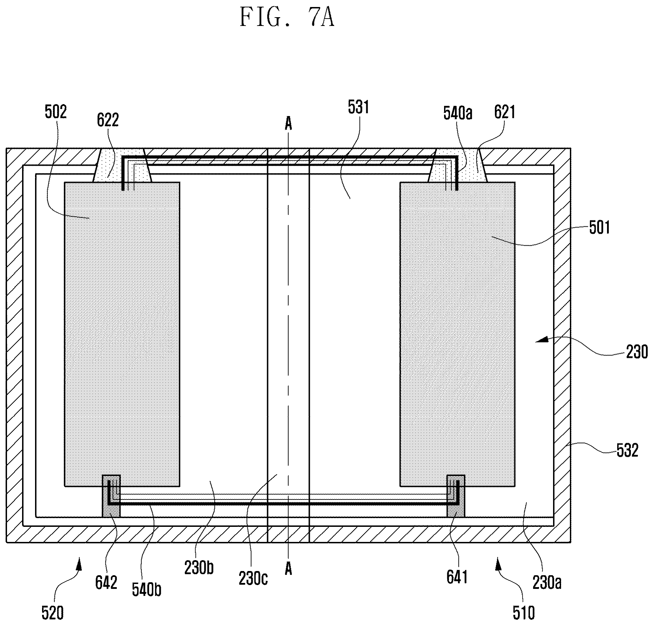

According to an embodiment, electrical components constituting an electronic device 500 (e.g., the electronic device 101 of FIG. 1 or the electronic device 200 of FIG. 2A) may be disposed in a first housing 510 (e.g., the first housing 210 of FIG. 2A) and a second housing 520 (e.g., the second housing 220 of FIG. 2A). For example, referring to FIG. 6A, the electronic device 500 may include a first printed circuit board 501 (e.g., the first substrate 271 of FIG. 4) disposed in the first housing 510 and a second printed circuit board 502 (e.g., the second substrate 272 of FIG. 4) disposed in the second housing 520. The first printed circuit board 501 and the second printed circuit board 502 may be electrically connected to a plurality of electronic components. The electronic device 500 may include an electrical connection configuration that electrically connects the electronic components that are separately disposed in the first housing 510 and the second housing 520. For example, the electronic device 500 may include a flexible printed circuit board that electrically interconnects the first printed circuit board 501 and the second printed circuit board 502. The flexible printed circuit board may pass through the hinge devices 400 and 400-1 and may be electrically connected to the first printed circuit board 501 and the second printed circuit board 502. In such a case, the flexible printed circuit board may be damaged as the electronic device 500 repeatedly performs folding and unfolding operations around the hinge devices 400 and 400-1. Accordingly, the first printed circuit board 501 and the second printed circuit board 502 may become electrically disconnected (shorted). According to an embodiment of the disclosure, as illustrated in FIGS. 6A and 7A, conductive circuits 540a and 540b may be disposed in the display module 230. The conductive circuits 540a and 540b may be patterned or arranged in the display module 230 to be electrically connected to the first printed circuit board 501 and the second printed circuit board 502. Details will be described below.

Meanwhile, the conductive circuits 540a and 540b may electrically connect various electrical components disposed separately in the first housing 510 and the second housing 520. Hereinafter, for convenience of description, it is assumed that the conductive circuits 540a and 540b are electrically connected to the first printed circuit board 501 and the second printed circuit board 502.

According to an embodiment, as illustrated in FIG. 6A, the display module 230 may include one or more conductive circuits 540a and 540b that electrically connect the first printed circuit board 501 and the second printed circuit board 502. In an embodiment, the display module 230 may include a display area 531 in which a screen is displayed and an opaque area 532 (e.g., a bezel area) surrounding the display area 531 and positioned at an outer periphery of the display module 230. In an embodiment, the conductive circuits 540a and 540b may be disposed in the display module 230 to be at least partially positioned in the opaque area 532. Accordingly, the visibility of the display module 230 to the user may not be obstructed by the conductive circuits 540a and 540b

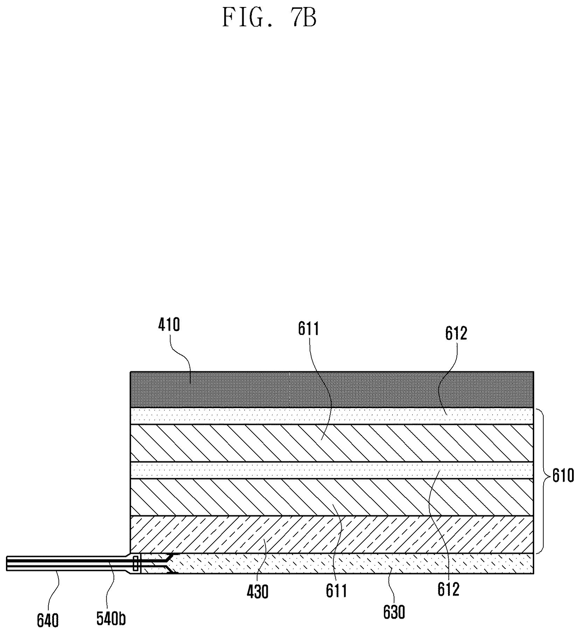

According to an embodiment, the conductive circuits 540a and 540b may be formed on various layers constituting the display module 230. In an embodiment, the conductive circuits may include a first conductive circuit 540a (e.g., the first conductive circuit 540a of FIG. 6B) formed on a touch panel 610 and/or a second conductive circuit 540b (e.g., the second conductive circuit 540b of FIG. 7B) formed on a digitizer panel 630.

In an embodiment, the first conductive circuit 540a may be formed on the touch panel 610 of the display module 230. In an embodiment, as illustrated in FIGS. 6A to 6C, the first conductive circuit 540a may be formed at an outer periphery of the touch panel 610 so that at least a portion thereof is positioned in the opaque area 532 of the display module 230. The first conductive circuit 540a may pass through the hinge devices 400 and 400-1 and may be electrically connected to the first printed circuit board 501 and the second printed circuit board 502.

According to an embodiment, the display module 230 may include a touch panel 610. In an embodiment, referring to FIG. 6B, the touch panel 610 may be disposed between a window layer 410 and a display panel 430. In an embodiment, the touch panel 610 may include a transparent electrode layer 611 (indium tin oxide (ITO)). In an embodiment, referring to FIG. 6B, the touch panel 610 may have a stacked structure in which transparent electrode layers 611 and optically clear adhesive (OCA) layers 612 are stacked.

In an embodiment, referring to FIGS. 6B and 6C, the first conductive circuit 540a may be patterned or arranged on the transparent electrode layers 611 of the touch panel 610 and may extend to a first connection portion 620 connected to the touch panel 610. In an embodiment, the first connection portion 620 may include a (1-1)^{th} connection portion 621 connected to the first printed circuit board 501 and a (1-2)^{th} connection portion 622 connected to the second printed circuit board 502. In an embodiment, the touch panel 610 may include a first touch panel (not illustrated) disposed in the first housing 510 and a second touch panel (not illustrated) disposed in the second housing 520. The (1-1)^{th} connection portion 621 may be connected to the first touch panel to be electrically connected to the first printed circuit board 501. The (1-2)^{th} connection portion 622 may be connected to the second touch panel to be electrically connected to the second printed circuit board 502. The first conductive circuit 540a may extend from the transparent electrode layer 611 to the (1-1)^{th} connection portion 621 and the (1-2)^{th} connection portion 622 to be electrically connected to the first printed circuit board 501 and the second printed circuit board 502. Accordingly, the first printed circuit board 501 and the second printed circuit board 502 may be electrically connected via the first conductive circuit 540a. In addition, at least a portion of the first conductive circuit 540a may be formed at an outer periphery of the transparent electrode layer 611 and may be positioned in the opaque area 532 of the display module 230. Accordingly, the visibility of the display module 230 to the user may not be obstructed by the first conductive circuit 540a.

In an embodiment, referring to FIG. 6D, the touch panel 610 (e.g., the first touch panel and/or the second touch panel) may be implemented using an on-cell touch AMOLED (OCTA) method. For example, touch wiring of the touch panel 610 may be patterned on a protective layer 431 laminated on a thin film transistor (TFT) layer 432 of the display panel, formed integrally with the protective layer 431, and connected to a touch circuit (e.g., TDDI) (not illustrated) of the electronic device 500. In addition, in an embodiment, the first conductive circuit 540a may be patterned on the protective layer 431 of the display panel to be formed integrally with the protective layer 431. In such a case, the first connection portion 620 may be connected to the display panel 430 on which the protective layer 431 is formed. The first connection portion 620 may include a (1-1)^{th} connection portion 621 connected to the first printed circuit board 501 and a (1-2)^{th} connection portion 622 connected to the second printed circuit board 502. The first conductive circuit 540a may extend from the protective layer 431 to the (1-1)^{th} connection portion 621 and the (1-2)^{th} connection portion 622 so as to be electrically connected to the printed circuit boards 501 and 502. Accordingly, since the touch panel 610 is not separately disposed in the display module 230, the thickness of the display module 230 may be reduced.

In an embodiment, ground may be disposed around the first conductive circuit 540a placed on the touch panel 610. For example, among various layers of the touch panel 610, conductive members used as a ground (not illustrated) may be disposed above or below the layer on which the first conductive circuit 540a is formed. Accordingly, static charges around the touch panel 610 may move to the conductive members, thereby improving the electrical shielding of the first conductive circuit 540a.

FIG. 7A is a view illustrating a state in which a first printed circuit board and a second printed circuit board are connected via a second conductive circuit formed on a digitizer panel of a display module, according to an embodiment of the disclosure. FIG. 7B is a view illustrating a stacked state of components constituting the display module, according to an embodiment of the disclosure.

According to an embodiment, the digitizer panel 630 may include a plurality of signal patterns. In an embodiment, the digitizer panel 630 may include a plurality of layers, and the plurality of signal patterns may be included in different layers. The plurality of signal patterns included in different layers may be connected through via holes formed in the digitizer panel 630. The plurality of signal patterns may be connected to form a conductive loop. When a current is applied to the conductive loop, a magnetic field may be generated. When a pen approaches the digitizer panel 630, a coil included in the pen may induce an electromagnetic resonance phenomenon with the conductive loop.

According to an embodiment, as illustrated in FIGS. 7A and 7B, the second conductive circuit 540b may be patterned or arranged on at least one of the plurality of layers of the digitizer panel. The second conductive circuit 540b may extend to a second connection portion 640 connected to a layer of the digitizer panel 630. In an embodiment, the second connection portion 640 may include a (2-1)^{th} connection portion 641 connected to the first printed circuit board 501 (e.g., the first substrate 271 of FIG. 4) and a (2-2)^{th} connection portion 642 connected to the second printed circuit board 502 (e.g., the second substrate 272 of FIG. 4). In an embodiment, the digitizer panel 630 may include a first digitizer panel (e.g., the first digitizer panel 471 of FIG. 5) disposed in a first housing 510 (e.g., the first housing 210 of FIG. 2A) and a second digitizer panel (e.g., the second digitizer panel 472 of FIG. 5) disposed in a second housing 520 (e.g., the second housing 220 of FIG. 2A). The (2-1)^{th} connection portion 641 may be connected to the first digitizer panel 471 to be electrically connected to the first printed circuit board 501. The (2-2)^{th} connection portion 642 may be connected to the second digitizer panel 472 to be electrically connected to the second printed circuit board 502. The second conductive circuit 540b may extend, in one of the layers of the digitizer panel 630, to the (2-1)^{th} connection portion 641 and the (2-2)^{th} connection portion 642 to be electrically connected to the first printed circuit board 501 and the second printed circuit board 502. In addition, at least a portion of the second conductive circuit 540b may be formed at an outer periphery of the digitizer panel 630 and may be positioned in the opaque area 532 of the display module 230. Accordingly, the visibility of the display module 230 to the user may not be obstructed by the second conductive circuit 540b. However, in some embodiments, the digitizer panel 630 may be positioned in a display area 531 of the display module 230. In such a case, the second conductive circuit 540b disposed on the digitizer panel 630 may be positioned in the display area 531 of the display module 230.

According to an embodiment, the first printed circuit board 501 and the second printed circuit board 502 may be electrically connected through a plurality of conductive circuits 540a and 540b as needed. For example, referring to FIG. 7A, the first printed circuit board 501 and the second printed circuit board 502 may be electrically connected through the first conductive circuit 540a (e.g., the first conductive circuit 540a of FIG. 6B) formed on the touch panel 610 and the second conductive circuit 540b (e.g., the second conductive circuit 540b of FIG. 7B) formed on the digitizer panel 630. In an embodiment, the first conductive circuit 540a disposed on the touch panel 610 and the second conductive circuit 540b disposed on the digitizer panel 630 may be spaced apart from each other and arranged to face each other. As the first printed circuit board 501 and the second printed circuit board 502 are electrically connected through the plurality of conductive circuits 540a and 540b, electrically stable connectivity may be ensured.

In an embodiment, Table 1 below shows performance characteristics of C-PHY and D-PHY, which represent interfaces between a camera and a display among the components constituting MIPI (Mobile Industry Processor Interface).

Table 1 below shows the signal widths of the display module 230.

**[Table 1]**

| | D-PHY ver1.2 | C-PHY ver 1.0 |
|---|---|---|
| Bandwidth | bps | 17.1 Gbps |
| Configuration | in (4 lane + I2C) | 9 pin (3 lane) |
| Pin/lane | 2 | 3 |
| Bandwidth/lane | 2.5 Gbps | 5.7 Gbps |
| Bandwidth/pin | 1.25 Gbps | 1.9 Gbps |

Under these conditions, a signal based on a display serial interface (DSI) signal may be configured to transmit a bandwidth of 1.25 Gbps per line. In such a case, the conductive circuits 540a and 540b may be used as elements for transmitting signals from the camera module by adjusting their impedance. According to an embodiment of the disclosure, the conductive circuits 540a and 540b may be formed on various layers of the display module 230. In an embodiment, the conductive circuits 540a and 540b may be formed or disposed on a touch panel 610 and/or a digitizer panel 630 of the display module 230. Electrical components (e.g., the first printed circuit board 501 and the second printed circuit board 502) that are separately disposed in the first housing 510 and the second housing 520 may be electrically connected through the conductive circuits 540a and 540b. In such a case, since a separate electrical member (e.g., a flexible printed circuit board) for connecting the first printed circuit board 501 and the second printed circuit board 502 is not disposed, the component arrangement space within the electronic device 500 may be expanded. In the foregoing description, it has been assumed that the conductive circuits 540a and 540b are formed on the touch panel 610 and/or the digitizer panel 630 of the display module 230, but the disclosure may not be limited thereto. The conductive circuits 540a and 540b may be formed on various layers constituting the display module 230 within a range that can be implemented by those ordinarily skilled in the art. For example, the conductive circuits 540a and 540b may be formed on a portion of the display panel to be electrically connected to electrical components (e.g., the first printed circuit board 501 and/or the second printed circuit board 502) that are separately disposed in the first housing 510 and the second housing 520.

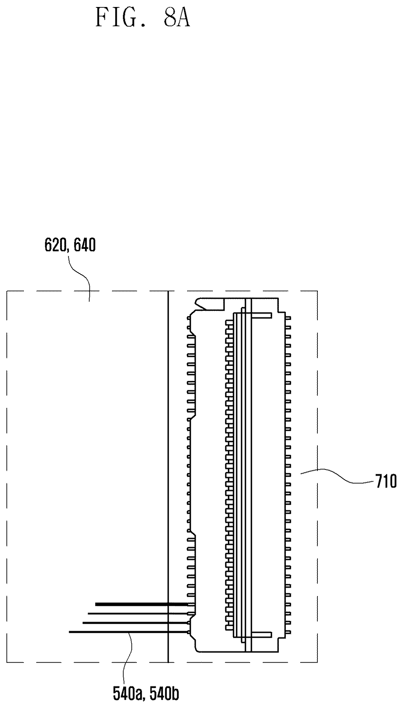

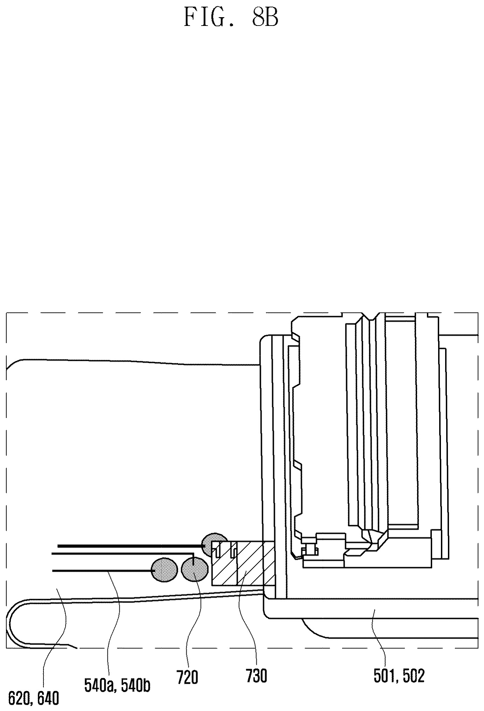

FIGS. 8A and 8B are views illustrating a connection between conductive circuits of a display module and first and second printed circuit boards, according to an embodiment of the disclosure.

According to an embodiment, the conductive circuits 540a and 540b may be electrically connected to the first printed circuit board 501 (e.g., the first substrate 271 of FIG. 4) and/or the second printed circuit board 502 (e.g., the second substrate 272 of FIG. 4) through various methods. In an embodiment, referring to FIG. 8A, the conductive circuits 540a and 540b may be electrically connected to the first printed circuit board 501 and/or the second printed circuit board 502 via a connector 710. In an embodiment, at least one of a (1-1)^{th} connection portion 621 of the touch panel 610, a (1-2)^{th} connection portion 622 of the touch panel 610, a (2-1)^{th} connection portion 641 of the digitizer panel 630, and a (2-2)^{th} connection portion 642 of the digitizer panel 630 may be connected to the connector 710. For example, at least one of the (1-1)^{th} connection portion 621 and the (1-2)^{th} connection portion 622 of the touch panel 610 may be integrally formed with the connector 710 or connected to a separately formed connector 710. The first conductive circuit 540a of the touch panel 610 may extend to the connector 710 to be connected to the first printed circuit board 501 and/or the second printed circuit board 502. Likewise, at least one of the (2-1)^{th} connection portion 641 and the (2-2)^{th} connection portion 642 of the digitizer panel 630 may be integrally formed with the connector 710 or connected to a separately formed connector 710. The second conductive circuit 540b of the digitizer panel 630 may extend to the connector 710 to be connected to the first printed circuit board 501 and/or the second printed circuit board 502.

In an embodiment, referring to FIG. 8B, at least one of a (1-1)^{th} connection portion 621 of the touch panel 610, a (1-2)^{th} connection portion 622 of the touch panel 610, a (2-1)^{th} connection portion 641 of the digitizer panel 630, and a (2-2)^{th} connection portion 642 of the digitizer panel 630 may include a hole 720 through which the conductive circuits 540a and 540b are exposed. In an embodiment, at least one of the (1-1)^{th} connection portion 621 and the (1-2)^{th} connection portion 622 of the touch panel 610 may include a hole 720 through which the first conductive circuit 540a is exposed. The first conductive circuit 540a of the touch panel 610 may be exposed through the hole 720, such that a portion of a copper foil forming the first conductive circuit 540a is opened. The first conductive circuit 540a of the touch panel 610 may be in contact with a contact member 730 (e.g., a c-clip) disposed on at least one of the first printed circuit board 501 and the second printed circuit board 502 through the exposed portion of the copper foil. Accordingly, the conductive circuits 540a and 540b may be electrically connected to at least one of the first printed circuit board 501 and/or the second printed circuit board 502. Likewise, at least one of the (2-1)^{th} connection portion 641 and the (2-2)^{th} connection portion 642 of the digitizer panel 630 may include a hole 720 through which the second conductive circuit 540a is exposed. The second conductive circuit 540b of the digitizer panel 630 may be exposed through the hole 720, such that a portion of a copper foil forming the second conductive circuit 540b is opened. The second conductive circuit 540b of the digitizer panel 630 may be in contact with a contact member 730 disposed on at least one of the first printed circuit board 501 and the second printed circuit board 502 through the exposed portion of the copper foil. Accordingly, the second conductive circuit 540b of the digitizer panel 630 may be electrically connected to at least one of the first printed circuit board 501 and/or the second printed circuit board 502.

In addition, the first conductive circuit 540a of the touch panel 610 and the second conductive circuit 540b of the digitizer panel 630 may be electrically connected to the first printed circuit board 501 and the second printed circuit board 502 in various ways.

While the above description has been provided with respect to a foldable electronic device 500 in which a first housing 510 (e.g., the first housing 210 of FIG. 2A) and a second housing 520 (e.g., the second housing 220 of FIG. 2A) are foldably connected, the disclosure is not limited thereto. In an embodiment, the above-described structure may also be applied to a rollable electronic device 500 in which the first housing 510 and the second housing 520 are slidably connected. For example, an electrical component (e.g., the first printed circuit board 501) disposed in the first housing 510 and an electrical component (e.g., the second printed circuit board 502) disposed in the second housing 520 may be electrically connected through conductive circuits 540a and 540b disposed in a display module 230.

According to an embodiment of the disclosure, an electronic device 500 (e.g., the electronic device 101 of FIG. 1 and/or the electronic device 200 of FIG. 2A) may include a first housing 510 (e.g., the first housing 210 of FIG. 2A), a second housing 520 (e.g., the second housing 220 of FIG. 2A) connected to the first housing to be foldable with respect to the first housing, a first printed circuit board 501 (e.g., the first substrate 271 of FIG. 4) disposed in the first housing, a second printed circuit board 502 (e.g., the second substrate 272 of FIG. 4) disposed in the second housing, a display module 230 disposed on a front surface of the electronic device and including connection portions (e.g., the first connection portion 620 of FIG. 6B and the second connection portion 640 of FIG. 7B) that are partially deformed by movement of the second housing relative to the first housing and are respectively connected to the first printed circuit board and the second printed circuit board, and one or more conductive circuits 540 disposed in the display module and extending to the connection portions to be electrically connected to the first printed circuit board and the second printed circuit board.

The display module may further include a display area 531 in which a screen is displayed and an opaque area 532 surrounding the display area and positioned at an outer periphery of the display module, and the conductive circuits may be at least partially disposed in the display module to correspond to the opaque area.

The display module may include a touch panel 610 including a transparent electrode layer 611, and the connection portions of the display module may include a (1-1)^{th} connection portion 621 disposed on the touch panel and connected to the first printed circuit board, and a (1-2)^{th} connection portion 622 disposed on the touch panel and connected to the second printed circuit board. The conductive circuits may include a first conductive circuit 540a extending on the touch panel to the (1-1)^{th} connection portion and the (1-2)^{th} connection portion to be electrically connected to the first printed circuit board and the second printed circuit board.

The display module may further include a display area 531 in which a screen is displayed and an opaque area 532 surrounding the display area and positioned at an outer periphery of the display module, and the first conductive circuit may be formed along an outer periphery of a substrate of the touch panel and may be positioned in the opaque area.

In addition, the first conductive circuit may be formed on the transparent electrode layer of the touch panel, may extend to the (1-1)^{th} connection portion and the (1-2)^{th} connection portion, and may be electrically connected to the first printed circuit board and the second printed circuit board.

The display module may include a display panel 430 including a thin film transistor (TFT) and a protective layer 431 disposed on the thin film transistor, and the conductive circuits may include a first conductive circuit 540a formed on the protective layer.

The display module may include a digitizer panel 630 configured to recognize a pen input device, the connection portions of the display module may include a (2-1)^{th} connection portion 641 disposed on the digitizer panel and connected to the first printed circuit board, and a (2-2)^{th} connection portion 642 disposed on the digitizer panel and connected to the second printed circuit board, and the conductive circuits may include a second conductive circuit 540b extending on the digitizer panel to the (2-1)^{th} connection portion and the (2-2)^{th} connection portion and being electrically connected to the first printed circuit board and the second printed circuit board.

The display module may include a display area 531 in which a screen is displayed, and an opaque area 532 surrounding the display area and positioned at an outer periphery of the display module, and the second conductive circuit may be formed along an outer edge of the digitizer panel and positioned in the opaque area.

The electronic device may further include a connector 710 configured to connect the display module to at least one of the first printed circuit board and the second printed circuit board, and the conductive circuits extend to the connector.

The connection portions of the display module may include a hole 720 in which a portion of the conductive circuits is exposed, and the conductive circuits may be in contact, through the hole, with a contact member 730 disposed on at least one of the first printed circuit board and the second printed circuit board.

According to an embodiment, in a display module 230, which is disposed in a foldable electronic device 500 (e.g., the electronic device 101 of FIG. 1 or the electronic device 200 of FIG. 2A) including a first housing 510 (e.g., the first housing 210 of FIG. 2A) and a second housing 520 (e.g., the second housing 220 of FIG. 2A) foldably connected to the first housing, the display module may include connection portions (e.g., the first connection portion 620 of FIG. 6B and/or the second connection portion 640 of FIG. 6B) disposed in the display module and respectively connected to a first printed circuit board 501 (e.g., the first substrate 271 of FIG. 4) disposed in the first housing and a second printed circuit board 502 (e.g., the second substrate 272 of FIG. 4) disposed in the second housing, and one or more conductive circuits 540a and 540b disposed in the display module extending to the connection portions and being electrically connected to the first printed circuit board and the second printed circuit board.

The display module may further include a display area 531 in which a screen is displayed and an opaque area 532 surrounding the display area and positioned at an outer periphery of the display module, and at least a portion of the conductive circuit may be disposed in the display module to correspond to the opaque area.

The display module may include a touch panel 610 including a transparent electrode layer 611, the connection portions of the display module may include a (1-1)^{th} connection portion 621 disposed on the touch panel and connected to the first printed circuit board, and a (1-2)^{th} connection portion 622 disposed on the touch panel and connected to the second printed circuit board, and the conductive circuits may include a first conductive circuit (540a) extending on the touch panel to the (1-1)^{th} connection portion and the (1-2)^{th} connection portion to be electrically connected to the first printed circuit board and the second printed circuit board.

The display module may further include a display area 531 in which a screen is displayed and an opaque area 532 surrounding the display area and positioned at an outer periphery of the display module, and the first conductive circuit may be formed along an outer periphery of a substrate of the touch panel and may be positioned in the opaque area.

In addition, the first conductive circuit may be formed on the transparent electrode layer of the touch panel, may extend to the (1-1)^{th} connection portion and the (1-2)^{th} connection portion, and may be electrically connected to the first printed circuit board and the second printed circuit board.

The display module may include a display panel 430 including a thin film transistor (TFT) and a protective layer 431 disposed on the thin film transistor, and the conductive circuits may include a first conductive circuit 540a formed on the protective layer.

The display module may include a digitizer panel 630 configured to recognize a pen input device, the connection portions of the display module may include a (2-1)^{th} connection portion 641 disposed on the digitizer panel and connected to the first printed circuit board, and a (2-2)^{th} connection portion 642 disposed on the digitizer panel and connected to the second printed circuit board, and the conductive circuits may include a second conductive circuit 540b extending on the digitizer panel to the (2-1)^{th} connection portion and the (2-2)^{th} connection portion, and electrically connected to the first printed circuit board and the second printed circuit board.

The display module may include a display area 531 in which a screen is displayed, and an opaque area 532 surrounding the display area and located at an outer periphery of the display module. The second conductive circuit may be formed along the outer periphery of the digitizer panel to be positioned in opaque area.

The display module may further include a connector 710 configured to connect the display module to at least one of the first printed circuit board and the second printed circuit board, and the conductive circuits may extend to the connector.

The connection portions of the display module may include a hole 720 in which a portion of the conductive circuits is exposed, and the conductive circuits may be in contact, through the hole, with a contact member 730 disposed on at least one of the first printed circuit board and the second printed circuit board.

## Claims

1. An electronic device (101, 200, 500) comprising:
a first housing (210, 510);
a second housing (220, 520) connected to the first housing to be foldable with respect to the first housing;
a first printed circuit board (271, 501) disposed in the first housing;
a second printed circuit board (272, 502) disposed in the second housing;
a display module (230) disposed on a front surface of the electronic device, the display module comprising connection portions (620, 640) that are partially deformed by movement of the second housing relative to the first housing and are respectively connected to the first printed circuit board and the second printed circuit board; and
one or more conductive circuits (540a, 540b) disposed in the display module and extending to the connection portions to be electrically connected to the first printed circuit board and the second printed circuit board.

2. The electronic device of claim 1, wherein the display module comprises a display area (531) in which a screen is displayed, and an opaque area (532) surrounding the display area and positioned at an outer periphery of the display module, and
wherein the conductive circuits are at least partially disposed in the display module to correspond to the opaque area.

3. The electronic device of claim 1, wherein the display module comprises a touch panel (610) comprising a transparent electrode layer (611),
wherein the connection portions of the display module comprise a (1-1)^{th} connection portion (621) disposed on the touch panel and connected to the first printed circuit board, and a (1-2)^{th} connection portion (622) disposed on the touch panel and connected to the second printed circuit board, and
wherein the conductive circuits comprise a first conductive circuit (540a) extending on the touch panel to the (1-1)^{th} connection portion and the (1-2)^{th} connection portion to be electrically connected to the first printed circuit board and the second printed circuit board.

4. The electronic device of claim 3, wherein the display module comprises a display area (531) in which a screen is displayed, and an opaque area (532) surrounding the display area and positioned at an outer periphery of the display module, and
wherein the first conductive circuit is formed along an outer periphery of the touch panel and is positioned in the opaque area.

5. The electronic device of claim 3, wherein the first conductive circuit is formed on the transparent electrode layer of the touch panel, extends to the (1-1)^{th} connection portion and the (1-2)^{th} connection portion, and is electrically connected to the first printed circuit board and the second printed circuit board.

6. The electronic device of claim 1, wherein the display module comprises a display panel (430) comprising a thin film transistor (TFT) and a protective layer (431) disposed on the thin film transistor, and
wherein the conductive circuits comprise a first conductive circuit (540a) formed on the protective layer.

7. The electronic device of claim 1, wherein the display module comprises a digitizer panel (630) configured to recognize a pen input device,
wherein the connection portions of the display module comprise a (2-1)^{th} connection portion (641) disposed on the digitizer panel and connected to the first printed circuit board, and a (2-2)^{th} connection portion (642) disposed on the digitizer panel and connected to the second printed circuit board, and
wherein the conductive circuits comprise a second conductive circuit (540b) extending on the digitizer panel to the (2-1)^{th} connection portion and the (2-2)^{th} connection portion and being electrically connected to the first printed circuit board and the second printed circuit board.

8. The electronic device of claim 7, wherein the display module comprises a display area (531) in which a screen is displayed, and an opaque area (532) surrounding the display area and positioned at an outer periphery of the display module, and
wherein the second conductive circuit is formed along an outer edge of the digitizer panel and is positioned in the opaque area.

9. The electronic device of claim 1, further comprising:
a connector (710) configured to connect the display module to at least one of the first printed circuit board and the second printed circuit board,
wherein the conductive circuits extend to the connector.

10. The electronic device of claim 1, wherein the connection portions of the display module comprise a hole (720) in which a portion of the conductive circuits is exposed, and
wherein the conductive circuits are in contact, through the hole, with a contact member (730) disposed on at least one of the first printed circuit board and the second printed circuit board.

11. A display module (230) disposed in a foldable electronic device (101, 200, 500) comprising a first housing (210, 510) and a second housing (220, 520) foldably connected to the first housing, the display module comprising:
connection portions (620, 640) disposed in the display module and respectively connected to a first printed circuit board (271, 501) disposed in the first housing and a second printed circuit board (272, 502) disposed in the second housing; and
one or more conductive circuits (540a, 540b) disposed in the display module, the conductive circuits extending to the connection portions and being electrically connected to the first printed circuit board and the second printed circuit board.

12. The display module of claim 11, further comprising:
a touch panel (610) comprising a transparent electrode layer (611),
wherein the connection portions of the display module comprise a (1-1)^{th} connection portion (621) disposed on the touch panel and connected to the first printed circuit board, and a (1-2)^{th} connection portion (622) disposed on the touch panel and connected to the second printed circuit board, and
wherein the conductive circuits comprise a first conductive circuit (540a) at least partially formed on the transparent electrode layer, extending to the (1-1)^{th} connection portion and the (1-2)^{th} connection portion, and electrically connected to the first printed circuit board and the second printed circuit board.

13. The display module of claim 11 or 12, further comprising:
a display area (531) in which a screen is displayed; and
an opaque area (532) surrounding the display area and located at an outer periphery of the display module,
wherein the conductive circuits are at least partially disposed in the display module to correspond to the opaque area.

14. The display module of claim 11, further comprising:
a display panel (430) comprising a thin film transistor (TFT) and a protective layer disposed on the thin film transistor,
wherein the conductive circuits comprise a first conductive circuit (540a) formed on the protective layer.

15. The display module of claim 11, further comprising:
a digitizer panel (630) configured to recognize a pen input device,
wherein the connection portions of the display module comprise a (2-1)^{th} connection portion (641) disposed on the digitizer panel and connected to the first printed circuit board, and a (2-2)^{th} connection portion (642) disposed on the digitizer panel and connected to the second printed circuit board, and
wherein the conductive circuits comprise a second conductive circuit (540b) extending on the digitizer panel to the (2-1)^{th} connection portion and the (2-2)^{th} connection portion, and electrically connected to the first printed circuit board and the second printed circuit board.
